# EUROPEAN PATENT APPLICATION

(11) **EP 4 503 882 A1**
(43) Date of publication of application: **05.02.2025**
(21) Application number: 24191802.8
(22) Date of filing: 30.07.2024
(51) Int. Cl.: H05K 13/00, H05K 1/02, H05K 13/04, H05K 13/08

(54) **MOUNTING DEVICE, ELECTRONIC DEVICE MANUFACTURING SYSTEM, MOUNTING METHOD, AND ELECTRONIC DEVICE MANUFACTURING DEVICE**

(30) Priority: 31.07.2023 JP 2023124777
(71) Applicant: JUKI Corporation, Tama-shi, Tokyo 206-8551 (JP)
(72) Inventor: NAKAGAWA, Shohei, Tokyo, 206-8551 (JP); MAEKAWA, Koki, Tokyo, 206-8551 (JP); NOYORI, Yoshitaka, Tokyo, 206-8551 (JP); OHNO, Katsuhiko, Tokyo, 206-8551 (JP)
(74) Representative: Hoeger, Stellrecht & Partner Patentanwälte mbB

(57) **Abstract**

A mounting device including a stage, a mounting head, a measurement data acquisition unit, a data comparison unit that compares design data and measurement data of a surface of a three-dimensional substrate and extracts a mounting position in the measurement data, a substrate data calculation unit that calculates substrate data including a rotation angle for horizontally aligning the surface at the mounting position based on a difference in coordinates between the design data and the measurement data, a stage control unit that controls the stage to horizontally align the surface of the three-dimensional substrate at the mounting position based on the substrate data, and a head control unit that controls the mounting head so that the component is mounted at the mounting position while the surface of the three-dimensional substrate at the mounting position is horizontally aligned.

## Description

### TECHNICAL FIELD

A technology disclosed in the present specification relates to a mounting device, an electronic device manufacturing system, a mounting method, and an electronic device manufacturing method.

### BACKGROUND ART

In a technical field relating to a mounting device, a three-dimensional mounting device that mounts a component on a three-dimensional substrate, such as that disclosed in Patent Literature 1, has been known.

### CITATION LIST

### PATENT LITERATURE

Patent Literature 1: WO2018/207313A

### SUMMARY OF INVENTION

### TECHNICAL PROBLEM

When mounting a component on a three-dimensional substrate, it is necessary to control a stage supporting the three-dimensional substrate so that a mounting position of the component on a surface of the three-dimensional substrate is horizontal. For example, when a three-dimensional substrate is formed by bonding a film to a base material with a curved surface, bonding errors between the base material and the film can cause a position of an electrical circuit on the film to shift, resulting in a variation in a mounting position. Therefore, the mounting device of the related art is cumbersome in that teaching processing needs to be performed one point at a time using a camera installed adjacent to a mounting head based on a curvature of a curved substrate.

An object of a technology disclosed in the present specification is to easily perform teaching processing on a three-dimensional substrate.

### SOLUTION TO PROBLEM

The present specification discloses a mounting device. The mounting device includes a stage that supports a three-dimensional substrate, a mounting head that mounts a component on the three-dimensional substrate, a measurement data acquisition unit that acquires measurement data of a three-dimensional shape of a surface of the three-dimensional substrate, a data comparison unit that compares design data and the measurement data of the surface of the three-dimensional substrate and extracts a mounting position in the measurement data corresponding to a predetermined mounting position in the design data, a substrate data calculation unit that calculates substrate data including a rotation angle for horizontally aligning the surface of the three-dimensional substrate at the mounting position based on a difference in coordinates between the design data and the measurement data at the mounting position, a stage control unit that controls the stage to horizontally align the surface of the three-dimensional substrate at the mounting position based on the substrate data, and a head control unit that controls the mounting head so that the component is mounted at the mounting position while the surface of the three-dimensional substrate at the mounting position is horizontally aligned.

### ADVANTAGEOUS EFFECTS OF INVENTION

According to the technology disclosed in the present specification, teaching processing on a three-dimensional substrate can be easily performed.

### BRIEF DESCRIPTION OF DRAWINGS

FIG. 1 is a perspective view illustrating a substrate and a component according to an embodiment.
FIG. 2 is a perspective view illustrating a pallet supporting the substrate according to the embodiment.
FIG. 3 is an exploded perspective view illustrating the substrate and the pallet according to the embodiment.
FIG. 4 is a schematic diagram illustrating a production system for an electronic device according to the embodiment.
FIG. 5 is a schematic diagram illustrating a three-dimensional measuring device and a mounting device according to the embodiment.
FIG. 6 is a schematic plan view illustrating the mounting device according to the embodiment.
FIG. 7 is a perspective view illustrating a conveying device and a stage according to the embodiment.
FIG. 8 is an exploded perspective view illustrating the conveying device and the stage according to the embodiment.
FIG. 9 is a perspective view illustrating the pallet and the stage according to the embodiment.
FIG. 10 is an exploded perspective view illustrating the pallet and the stage according to the embodiment.
FIG. 11 is a schematic diagram illustrating a mounting head according to the embodiment.
FIG. 12 is a schematic diagram illustrating a preheating device and a laser irradiation device according to the embodiment.
FIG. 13 is a schematic diagram illustrating a configuration of a management device according to the embodiment.
FIG. 14 is a diagram illustrating substrate data according to the embodiment.
FIG. 15 is a diagram illustrating the substrate data according to the embodiment.
FIG. 16 is a flowchart illustrating an electronic device manufacturing method according to the embodiment.
FIG. 17 is a diagram illustrating a mounting process by the mounting head according to the embodiment.
FIG. 18 is a diagram illustrating the mounting process by the mounting head according to the embodiment.
FIG. 19 is a diagram illustrating a method for controlling the stage.

### DESCRIPTION OF EMBODIMENTS

Hereinafter, an embodiment will be described with reference to the drawings. In the embodiment, an XYZ Cartesian coordinate system is defined, and a positional relationship of each unit will be described with reference to the XYZ Cartesian coordinate system. A direction parallel to an X-axis of a predetermined plane is defined as an X-axis direction. A direction parallel to a Y-axis of the predetermined plane perpendicular to the X-axis is defined as a Y-axis direction. A direction parallel to a Z-axis perpendicular to the predetermined plane is defined as a Z-axis direction. A direction of rotation or tilt around the X-axis direction is defined as a θX direction. A direction of rotation or tilt around the Y-axis direction is defined as a θY direction. A direction of rotation or tilt around the Z-axis direction is defined as a θZ direction. In the embodiment, the predetermined plane and a horizontal plane are parallel. The Z-axis is parallel to a vertical axis, and the Z-axis direction is an up-down direction. A +Z side is an upper side, and a - Z side is a lower side. The predetermined plane may be tilted with respect to the horizontal plane. In the embodiment, the predetermined plane including the X-axis and the Y-axis is appropriately referred to as an XY plane.

### Substrate

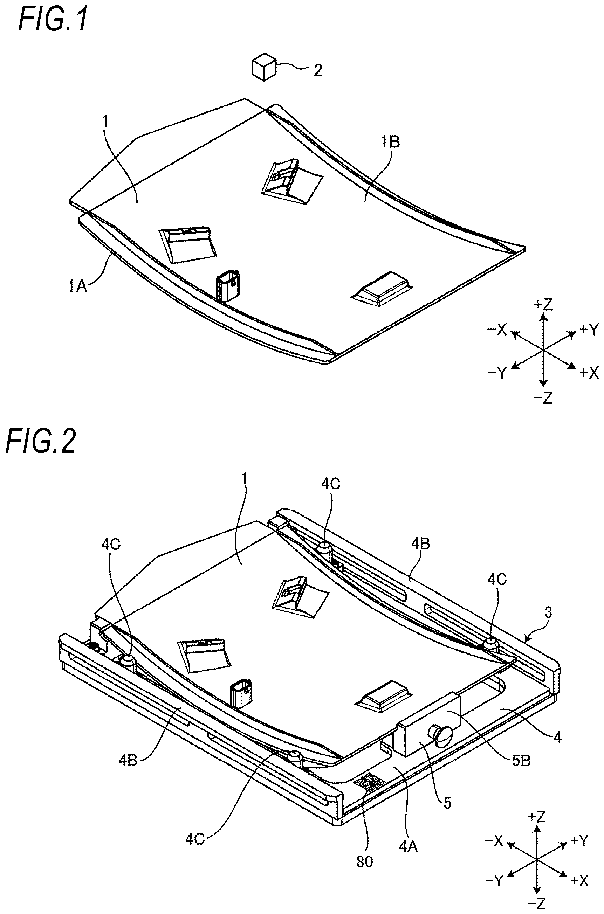

FIG. 1 is a perspective view illustrating a substrate 1 and a component 2 according to the embodiment. In the embodiment, the substrate 1 is a three-dimensional substrate. A three-dimensional substrate refers to a substrate having a non-planar surface. The surface of the substrate 1 includes a curved surface. At least a part of the surface of the substrate 1 is curved. The surface of the substrate 1 may include an angular portion. Protrusions may be provided on the surface of the substrate 1.

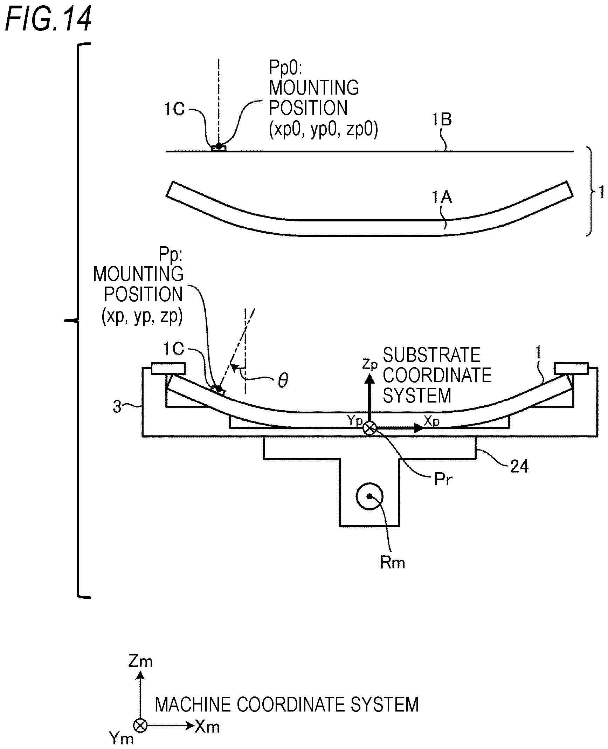

An electric circuit is provided on the surface of the substrate 1. In the embodiment, the substrate 1 is formed by in-mold molding technology. The substrate 1 includes a base material 1A having a curved surface, and a film 1B bonded to a surface of the base material 1A. The film 1B is flexible. The film 1B is a flexible film. The film 1B includes an electric circuit. The electric circuit includes an electrode such as a land and a pad (for example, an electrode 1C shown in FIG. 14 described below). A position (planar coordinates) of each electrode in the film 1B is assumed to be known. The surface of the substrate 1 includes the surface of the film 1B.

The component 2 includes an electronic component. The component 2 may be a lead-type electronic component having leads protruding from a body. The component 2 may be a chip-type electronic component having no leads. By mounting the component 2 on the surface of the substrate 1, an electronic device is manufactured.

### Pallet

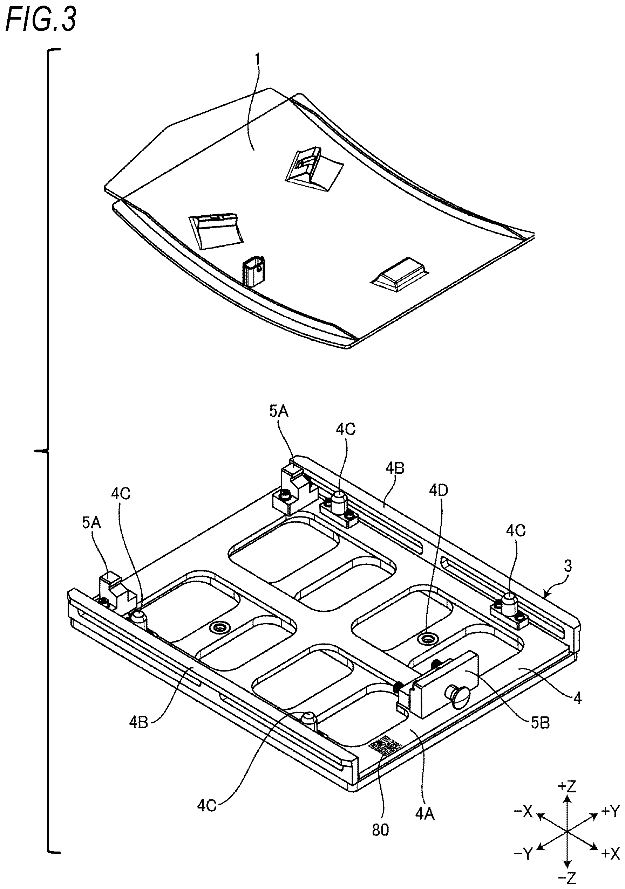

FIG. 2 is a perspective view illustrating a pallet 3 supporting the substrate 1 according to the embodiment. FIG. 3 is an exploded perspective view illustrating the substrate 1 and the pallet 3 according to the embodiment. The pallet 3 supports the substrate 1. In the embodiment, the substrate 1 is handled while being supported by the pallet 3. The pallet 3 includes a support member 4 that supports the substrate 1 and a clamp mechanism 5 that fixes the substrate 1.

The support member 4 includes a base portion 4A that supports the substrate 1 from the -Z side, guard portions 4B provided on each of the +Y side and -Y side of the base portion 4A, and a plurality of pin portions 4C that support the substrate 1 from each of the +Y side and -Y side.

The base portion 4A is has a plate shape with a plurality of openings. Two holes 4D are provided in the base portion 4A. The holes 4D penetrate top and bottom surfaces of the base portion 4A.

The guard portion 4B is long in the X-axis direction. A pair of guard portions 4B are provided. The pair of guard portions 4B are spaced apart in the Y-axis direction. One guard portion 4B protrudes toward the +Z side from a +Y side end of the top surface of the base portion 4A. The other guard portion 4B protrudes toward the +Z side from a -Y side end of the top surface of the base portion 4A.

Each of the plurality of pin portions 4C protrudes to the +Z side from the top surface of the base portion 4A. Some of the pin portions 4C are positioned on the +Y side of a center of the base portion 4A. Some of the pin portions 4C are positioned on the -Y side of the center of the base portion 4A. The plurality of pin portions 4C positioned on the +Y side of the center of the base portion 4A support a +Y side end of the substrate 1. The plurality of pin portions 4C positioned on the -Y side of the center of the base portion 4A support a -Y side end of the substrate 1.

The clamp mechanism 5 is provided on the support member 4. The clamp mechanism 5 fixes the substrate 1 to the support member 4. The clamp mechanism 5 includes a pair of support portions 5A that support a -X side end of the substrate 1, and a movable portion 5B that supports a +X side end of the substrate 1. The movable portion 5B is movable in the X-axis direction on the upper surface of the base portion 4A. With the substrate 1 disposed between the support portion 5A and the movable portion 5B, the movable portion 5B moves in the -X direction, thereby pinching the substrate 1 between the support portion 5A and the movable portion 5B. The substrate 1 is fixed to the pallet 3 by being pinched between the support portion 5A and the movable portion 5B.

In the embodiment, the pallet 3 includes an information medium 80. The information medium 80 stores substrate data related to the substrate 1. In the embodiment, the information medium 80 is a two-dimensional code. The information medium 80 may also be a one-dimensional barcode. The information medium 80 may also be an RF tag. In the embodiment, the information medium 80 is attached to a part of the upper surface of the base portion 4A. The information medium 80 is positioned not to overlap the substrate 1.

### Production System

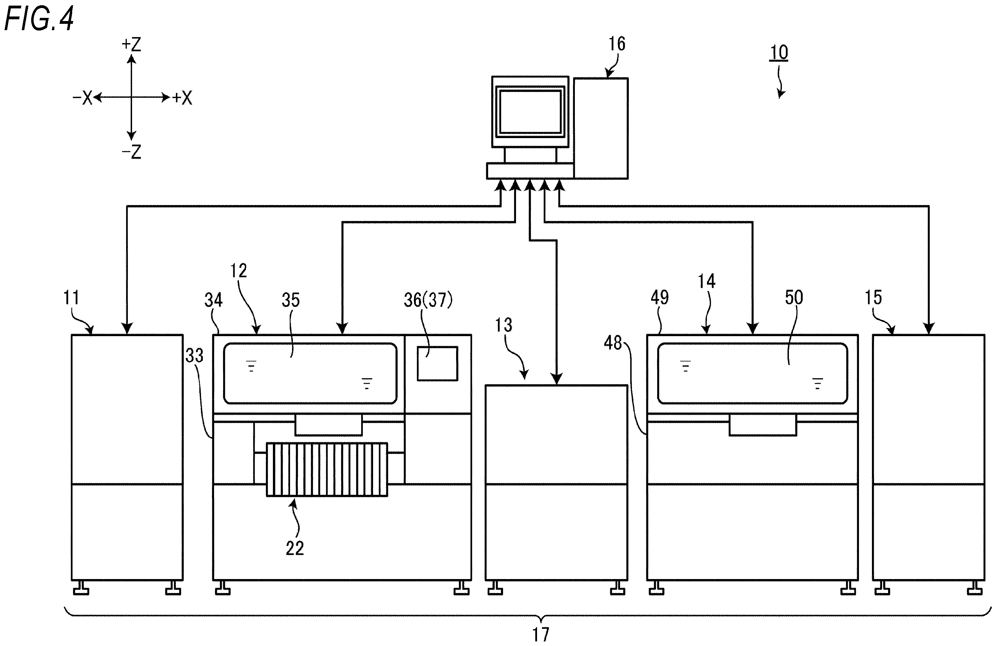

FIG. 4 is a schematic diagram illustrating a production system 10 for an electronic device according to the embodiment. As illustrated in FIG. 4, the production system 10 includes a three-dimensional measuring device 11, a mounting device 12, a preheating device 13, a laser irradiation device 14, an inspection device 15, and a management device 16. The three-dimensional measuring device 11, the mounting device 12, the preheating device 13, the laser irradiation device 14, and the inspection device 15 configure a production line 17 for an electronic device.

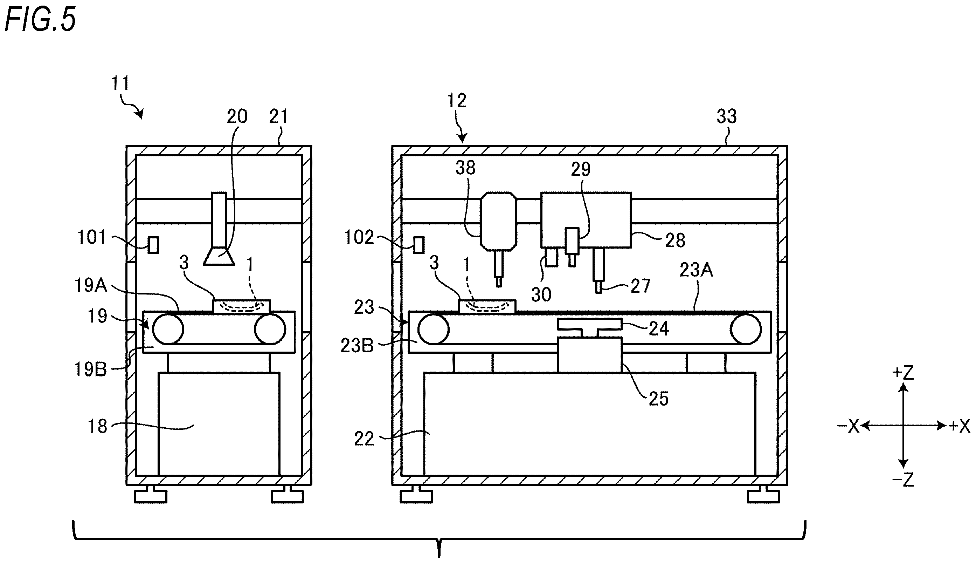

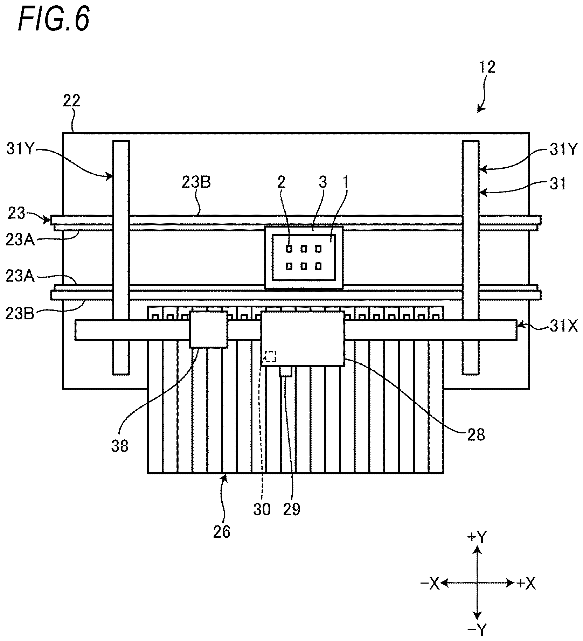

FIG. 5 is a schematic diagram illustrating the three-dimensional measuring device 11 and the mounting device 12 according to the embodiment. FIG. 6 is a schematic plan view illustrating the mounting device 12 according to the embodiment.

The three-dimensional measuring device 11 measures a three-dimensional shape of the surface of the substrate 1. The three-dimensional measuring device 11 includes a base member 18, a conveying device 19 that conveys the pallet 3, a sensor 20 that measures the three-dimensional shape of the surface of the substrate 1, and a chamber 21.

The base member 18 supports the conveying device 19. The conveying device 19 conveys the pallet 3 supporting the substrate 1 in the X-axis direction. The conveying device 19 includes a conveying belt 19A that conveys the pallet 3 and a guide member 19B that guides the pallet 3.

The sensor 20 measures the three-dimensional shape of the surface of the substrate 1. The sensor 20 includes, for example, a three-dimensional laser scanner. The sensor 20 acquires the Z coordinate of the surface of the substrate 1 fixed to the pallet 3 conveyed in the X-axis direction by the conveying device 19. The sensor 20 outputs the measured Z coordinate linked to the X and Y coordinates of a measurement position. The sensor 20 can, for example, simultaneously measure the Y-axis direction. Thereby, the sensor 20 acquires point cloud data of the surface of the substrate 1. The sensor 20 has a resolution sufficient to distinguish at least unevenness of an electrode (for example, the electrode 1C shown in FIG. 14 described below) disposed on the film 1B on the surface of the substrate 1. In the embodiment, the resolution of the sensor 20 is 2 µm.

The three-dimensional measuring device 11 may measure the three-dimensional shape of the surface of the substrate 1 based on, for example, a phase shift method. In the embodiment, the three-dimensional measuring device 11 measures the three-dimensional shape of the surface of the substrate 1 fixed to the pallet 3. The substrate 1 is measured by the three-dimensional measuring device 11 while being fixed to the pallet 3. Three-dimensional measurement data indicating the three-dimensional shape of the surface of the substrate 1 measured by the three-dimensional measuring device 11 is transmitted to the management device 16. The substrate 1 measured by the three-dimensional measuring device 11 is conveyed to the mounting device 12 while being fixed to the pallet 3.

The mounting device 12 mounts the component 2 on the substrate 1. At least one mounting device 12 is provided in the production line 17. A plurality of mounting devices 12 may be provided.

The mounting device 12 includes a base member 22, a conveying device 23, a stage 24, a stage moving device 25, a component supply device 26, a mounting head 28 including a nozzle 27, a substrate camera 29, a height sensor 30, a head moving device 31, a nozzle moving device 32, a chamber 33, an opening/closing cover 34, a window 35, a display device 36, and an input device 37.

The base member 22 supports each of the conveying device 23, the stage 24, the stage moving device 25, the component supply device 26, the mounting head 28, the head moving device 31, and the nozzle moving device 32.

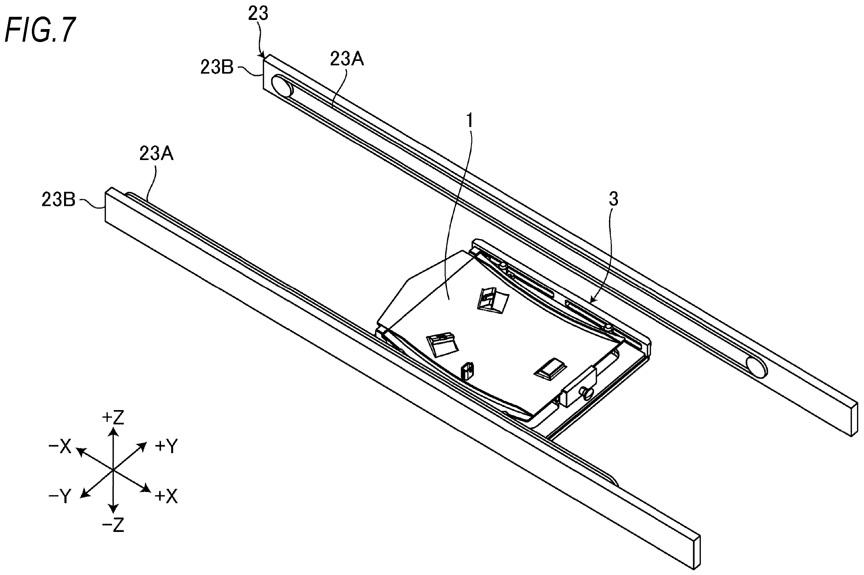

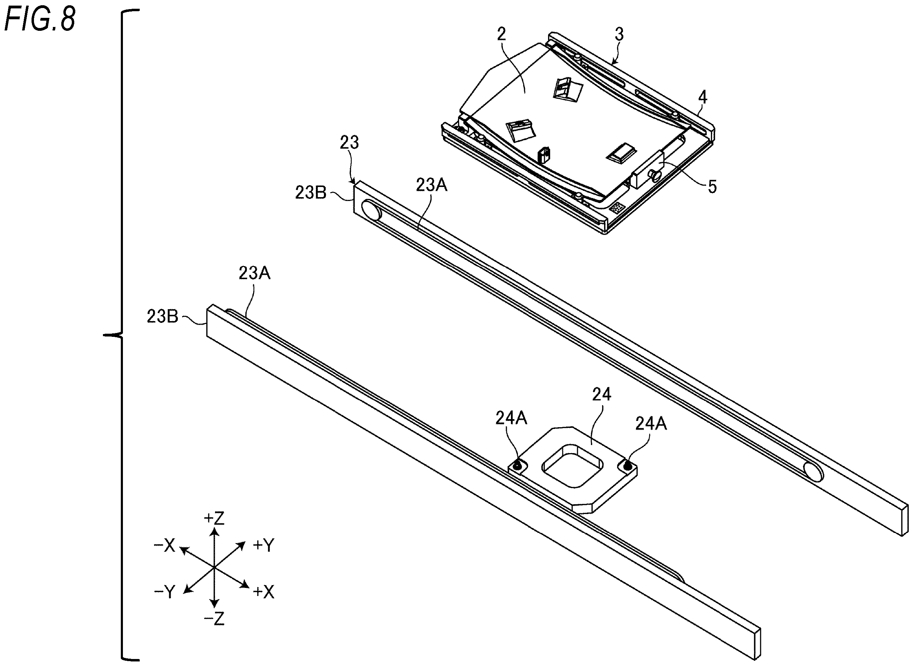

FIGS. 7 and 8 are a perspective view and an exploded perspective view illustrating the conveying device 23 and the stage 24 according to the embodiment.

The conveying device 23 conveys the pallet 3 supporting the substrate 1 in the X-axis direction. The conveying device 23 transports the pallet 3 supplied from the three-dimensional measuring device 11 to a processing position of the mounting device 12. The processing position is defined by a conveyance path of the conveying device 23.

The conveying device 23 includes a conveying belt 23A that conveys the pallet 3 in the X-axis direction, and a guide member 23B that guides the pallet 3.

The guide member 23B is long in the X-axis direction. A pair of guide members 23B are provided. The pair of guide members 23B are spaced apart from each other in the Y-axis direction. One guide member 23B is positioned on the +Y side of the pallet 3. The other guide member 23B is positioned on the -Y side of the pallet 3.

The conveying belt 23A is circular. A pair of conveying belts 23A are provided. The conveying belt 23A is supported by the guide member 23B via a driving pulley and a driven pulley. The conveying belt 23A is hung on the driving pulley and the driven pulley. One conveying belt 23A is supported by one guide member 23B. The other conveying belt 23A is supported by the other guide member 23B.

Of the pair of conveying belts 23A, the conveying belt 23A disposed on the +Y side supports a +Y side end of a bottom surface of the pallet 3. The conveying belt 23A disposed on the -Y side supports a -Y side end of the bottom surface of the pallet 3. The driving pulley is rotated by a drive motor (not illustrated), thereby conveying the pallet 3 in the X-axis direction.

An actuator (not illustrated) allows one guide member 23B to move in the Y-axis direction relative to the other guide member 23B. When one guide member 23B and the other guide member 23B move away from each other in the Y-axis direction, support of the pallet 3 by the conveying belt 23A is released.

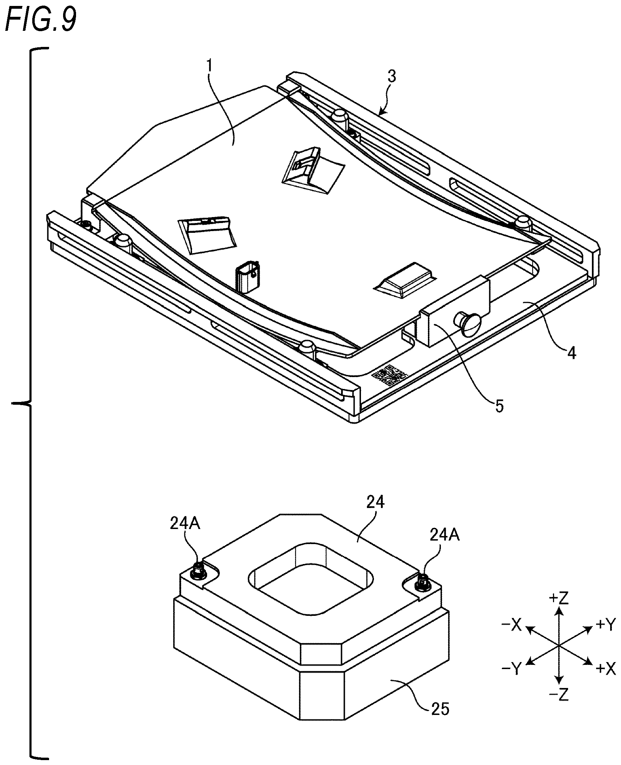

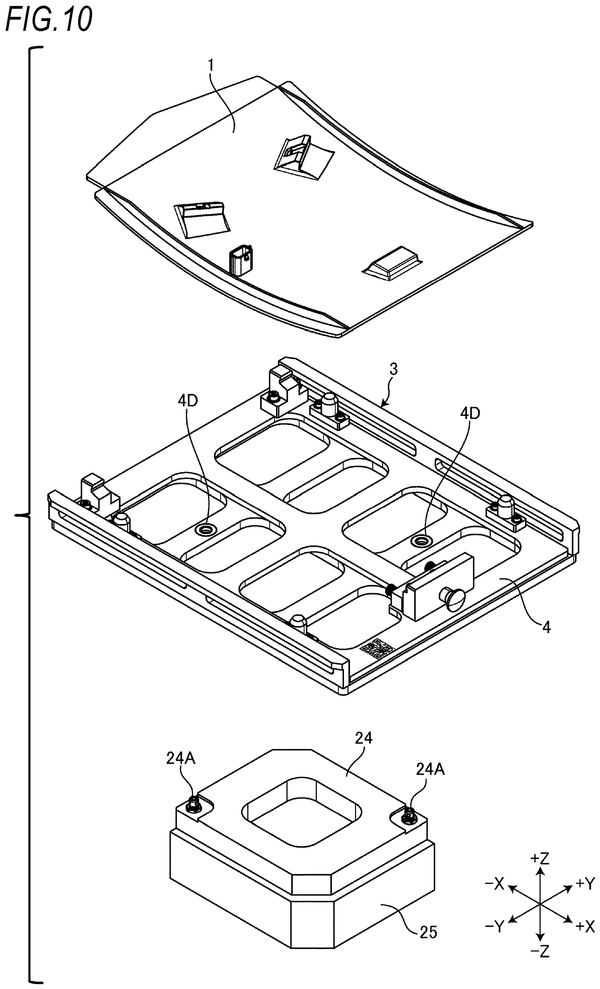

FIG. 9 is a perspective view illustrating the pallet 3 and the stage 24 according to the embodiment. FIG. 10 is an exploded perspective view illustrating the pallet 3 and the stage 24 according to the embodiment.

The stage 24 supports the substrate 1 via the pallet 3. The stage 24 supports the pallet 3 conveyed to the processing position from the -Z side. Two positioning members 24A are provided on an upper surface of the stage 24. The positioning members 24A are inserted into the holes 4D of the pallet 3. The stage 24 and pallet 3 are positioned by inserting the positioning members 24A into the holes 4D from the -Z side of the pallet 3. A hook is provided on an upper end of the positioning member 24A. The hook is hooked onto the pallet 3. The hook includes a ball that moves due to air pressure. After the positioning member 24A is inserted into the hole 4D from the -Z side of the pallet 3, the ball is hooked onto the pallet 3 to fix the stage 24 and the pallet 3.

The stage moving device 25 moves the stage 24. In the embodiment, the stage moving device 25 moves the stage 24 in each of the Y-axis direction, the Z-axis direction, the θX direction, and the θY direction. The stage moving device 25 includes a Y-axis motor that generates power to move the stage 24 in the Y-axis direction, a Z-axis motor that generates power to move the stage 24 in the Z-axis direction, a θX motor that generates power to rotate the stage 24 in the θX direction, and a θY motor that generates power to rotate the stage 24 in the θY direction.

After the pallet 3 is conveyed to the processing position by the conveying device 23, the guide member 23B on the +Y side moves in the +Y direction away from the other guide member 23B, and the stage moving device 25 moves the stage 24 in the +Z direction. The support of the pallet 3 by the conveying belt 23A is released by the guide member 23B on the +Y side moving in the Y-axis direction away from the other guide member 23B. As the support of the pallet 3 by the conveying belt 23A is released and the stage 24 moves in the +Z direction, the pallet 3 is transferred from the conveying device 23 to the stage 24. The stage moving device 25 moves the stage 24 in the +Y direction so that the stage 24 is in a center between the two guide members 23B while the pallet 3 is supported by the stage 24, making it possible to move the stage 24 in each of the Z-axis direction, the θX direction, and the θY direction.

When transferring the pallet 3 from the stage 24 to the conveying device 23, the stage 24 moves in the -Y direction until one side of the pallet 3 is on the conveying belt 23A, and the guide member 23B on the +Y side moves to the -Y side until the other side of the pallet 3 is on the conveying belt 23A. After fixing by the hook provided at the upper end of the positioning member 24A is released, the stage 24 moves in the -Z direction by the stage moving device 25. As a result, support of the pallet 3 by the stage 24 is released, and the pallet 3 is supported by the conveying belt 23A.

The component supply device 26 supplies the component 2. The component supply device 26 includes a plurality of tape feeders. The tape feeders hold a plurality of components 2. The component supply device 26 supplies at least one component 2 among the plurality of components 2 to a supply position. The component supply device 26 is disposed on the -Y side of the conveying device 23. The component supply devices 26 may be respectively disposed on both the +Y side and the -Y side of the conveying device 23.

The mounting head 28 mounts the component 2 on the substrate 1. The mounting head 28 supports a plurality of nozzles 27. The mounting head 28 holds the component 2 supplied from the component supply device 26 with the nozzle 27 and mounts the component 2 on the substrate 1. The mounting head 28 is movable between a supply position where the component 2 is supplied from the component supply device 26 and a processing position where the substrate 1 is disposed. The mounting head 28 holds the component 2 supplied to the supply position with the nozzle 27, moves the component 2 to the processing position, and then mounts the component 2 on the surface of the substrate 1 disposed at the processing position.

The head moving device 31 moves the mounting head 28. In the embodiment, the head moving device 31 moves the mounting head 28 in each of the X-axis and Y-axis directions. The head moving device 31 includes an X-axis moving device 31X that moves the mounting head 28 in the X-axis direction, and a Y-axis moving device 31Y that moves the mounting head 28 in the Y-axis direction. Each of the X-axis moving device 31X and the Y-axis moving device 31 Y includes an actuator. The X-axis moving device 31X is connected to the mounting head 28. The mounting head 28 moves in the X-axis direction by operating the X-axis moving device 31X. The Y-axis moving device 31Y is connected to the mounting head 28 via the X-axis moving device 31X. The X-axis moving device 31X moves in the Y-axis direction by operating the Y-axis moving device 31Y, thereby moving the mounting head 28 in the Y-axis direction.

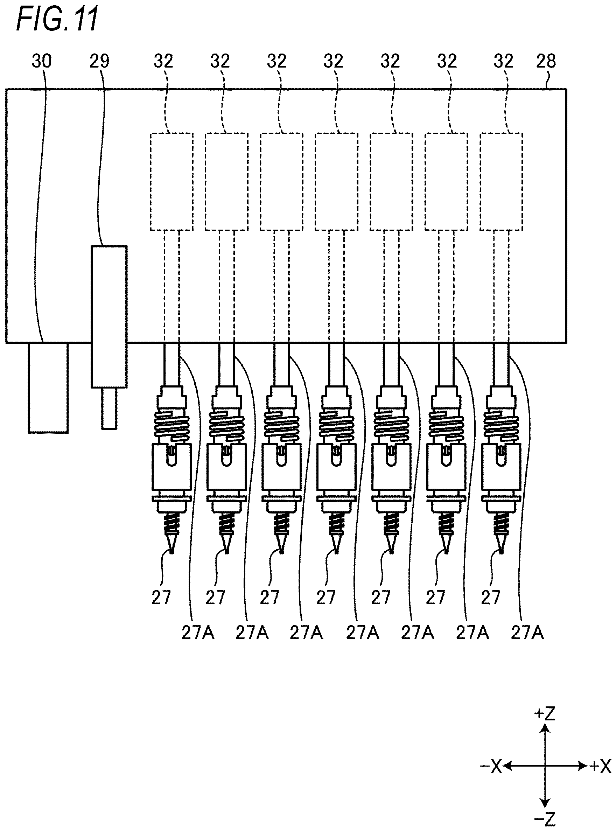

FIG. 11 is a schematic diagram of the mounting head 28 according to the embodiment. As illustrated in FIG. 11, the mounting head 28 includes the plurality of nozzles 27. The nozzle 27 detachably holds the component 2. The nozzle 27 is an adsorption nozzle that adsorbs and holds the component 2. An opening is provided at a lower end of the nozzle 27. The opening of the nozzle 27 is connected to a vacuum system. While a lower end of the nozzle 27 and the component 2 are in contact with each other, a suction operation is performed from an opening provided at the lower end of the nozzle 27, so that the component 2 is adsorbed and held at the lower end of the nozzle 27. The suction operation from the opening is released, so that the component 2 is released from the nozzle 27. The nozzle 27 may be a gripper nozzle that clamps and holds the component 2.

The nozzle moving device 32 moves the nozzle 27. In the embodiment, the nozzle moving device 32 moves the nozzle 27 in each of the Z-axis direction and the θZ direction. The nozzle moving device 32 is supported by the mounting head 28. The nozzle 27 is connected to a lower end of a shaft 27A. A plurality of shafts 27A are provided. The plurality of nozzles 27 are respectively connected to the plurality of shafts 27A. A plurality of nozzle moving devices 32 are provided. The plurality of nozzle moving devices 32 are respectively connected to the plurality of shafts 27A. The nozzle 27 is supported by the mounting head 28 via the shaft 27A and the nozzle moving device 32. The nozzle moving device 32 moves the nozzle 27 by moving the shaft 27A in the Z-axis direction and the θZ direction.

The nozzle 27 can be moved in each of the X-axis direction, the Y-axis direction, the Z-axis direction, and the θZ direction by the head moving device 31 and the nozzle moving device 32. By moving the nozzle 27, the component 2 held by the nozzle 27 can also be moved in each of the X-axis direction, the Y-axis direction, the Z-axis direction, and the θZ direction.

The substrate camera 29 images the substrate 1. In the embodiment, the substrate camera 29 images the surface of the substrate 1 from the +Z side of the substrate 1. The substrate camera 29 is provided on the mounting head 28. The substrate camera 29 moves in the X-axis direction and the Y-axis direction together with the mounting head 28. The substrate camera 29 can, for example, image an alignment mark provided on the surface of the substrate 1.

The height sensor 30 detects a height indicating a position of the surface of the substrate 1 in the Z-axis direction. The height sensor 30 is provided on the mounting head 28. The height sensor 30 moves in the X-axis direction and the Y-axis direction together with the mounting head 28. In the embodiment, the height sensor 30 is a laser positioning sensor. The height sensor 30 can detect a distance from the mounting head 28 to the substrate 1 by irradiating the surface of the substrate 1 with a laser beam from the +Z side of the substrate 1 and receiving the laser beam reflected by the surface of the substrate 1. The height of the surface of the substrate 1 is detected by detecting the distance from the mounting head 28 to the substrate 1.

The chamber 33 has an internal space in which the base member 22, the conveying device 23, the stage 24, the stage moving device 25, the component supply device 26, the mounting head 28, the head moving device 31, and the nozzle moving device 32 are each accommodated.

The opening/closing cover 34 opens and closes an opening provided at the top of the chamber 33. The opening/closing cover 34 is rotatably supported on at least a part of the chamber 33 via a hinge.

The window 35 is provided in the opening/closing cover 34. The window 35 is substantially transparent. An operator can visually check a state of the internal space of the chamber 33 through the window 35.

The display device 36 is provided on an outer surface of the chamber 33. The display device 36 displays display data. Examples of the display device 36 include a flat panel display such as a liquid crystal display or an organic EL display.

The input device 37 generates input data when operated by an operator. Examples of the input device 37 include a touch sensor, a computer keyboard, or a mouse. In the embodiment, the display device 36 is a touch screen that includes a touch sensor. The input device 37 includes the touch screen of the display device 36.

In the embodiment, the mounting device 12 includes a dispenser 38 that applies cream solder to the substrate 1. The dispenser 38 moves in the X-axis direction, the Y-axis direction, and the Z-axis direction on the +Z side of the conveying device 23. The dispenser 38 and the mounting head 28 can move separately. After the cream solder is applied to the surface of the substrate 1 by the dispenser 38, the mounting head 28 mounts the component 2 on the substrate 1. The substrate 1 on which the component 2 is mounted by the mounting device 12 is conveyed to the preheating device 13 while being fixed to the pallet 3.

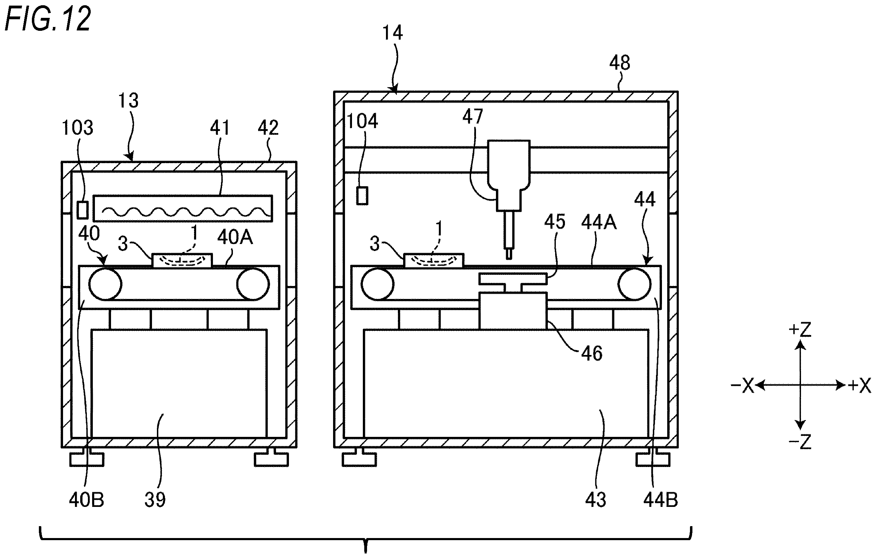

FIG. 12 is a schematic diagram illustrating the preheating device 13 and the laser irradiation device 14 according to the embodiment.

The preheating device 13 reduces a liquid component of the cream solder applied to the substrate 1. The cream solder contains flux and metallic solder balls dispersed in the flux. The preheating device 13 reduces the liquid component of the cream solder by activating the flux and vaporizing at least a part of the liquid component. The preheating device 13 includes a base member 39, a conveying device 40 that conveys the pallet 3, a heater 41 that heats the substrate 1, and a chamber 42.

The base member 39 supports the conveying device 40. The conveying device 40 conveys the pallet 3 supporting the substrate 1 in the X-axis direction. The conveying device 40 includes a conveying belt 40Athat conveys the pallet 3 and a guide member 40B that guides the pallet 3.

The heater 41 heats the substrate 1 so that at least a part of the liquid component of the flux of the cream solder is vaporized.

The chamber 42 has an internal space in which the base member 39, the conveying device 40, and the heater 41 are each accommodated.

The preheating device 13 heats the substrate 1 supported by the pallet 3 so that the liquid component of the cream solder is reduced. The preheating device 13 heats the substrate 1 at a temperature lower than a melting point of the cream solder. The preheating device 13 heats the substrate 1 for 10 minutes at a temperature of 80°C or higher and 100°C or lower, for example. The substrate 1 preheated by the preheating device 13 is conveyed to the laser irradiation device 14 while being fixed to the pallet 3.

The laser irradiation device 14 irradiates the cream solder with a laser beam so that the cream solder melts. The laser irradiation device 14 includes a base member 43, a conveying device 44 that conveys the pallet 3, a stage 45 that supports the pallet 3, a stage moving device 46 that moves the stage 45, a laser head 47 that emits a laser beam, a chamber 48, an opening/closing cover 49, and a window 50.

The base member 43 supports each of the conveying device 44, the stage 45, the stage moving device 46, and the laser head 47. The conveying device 44 conveys the pallet 3 supporting the substrate 1 in the X-axis direction. The conveying device 44 includes a conveying belt 44Athat conveys the pallet 3, and a guide member 44B that guides the pallet 3. The structure and the function of the conveying device 44 are substantially equivalent to the structure and the function of the conveying device 23.

The stage 45 supports the pallet 3 from the -Z side. The stage moving device 46 moves the stage 45 in the Y-axis direction, the Z-axis direction, the θX direction, and the θY direction. The structure and the function of the stage 45 are substantially equivalent to the structure and the function of the stage 24.

The laser head 47 irradiates the cream solder with a laser beam to melt the cream solder. The laser head 47 moves in the X-axis direction, the Y-axis direction, and the Z-axis direction on the +Z side of the conveying device 44.

The chamber 48 has an internal space in which the base member 43, the conveying device 44, the stage 45, the stage moving device 46, and the laser head 47 are each accommodated.

The opening/closing cover 49 opens and closes an opening provided at the top of the chamber 48. The opening/closing cover 49 is rotatably supported on at least a part of the chamber 48 via a hinge.

The window 50 is provided in the opening/closing cover 49. The window 50 reduces an amount of light rays that passes through. The operator can visually check a state of the internal space of the chamber 48 through the window 50. The window 50 has a dimming function and an anti-glare function, so that the operator's eyes are prevented from being damaged by reflection of the laser beam.

In the laser irradiation device 14, the cream solder is irradiated with the laser beam emitted from the laser head 47. The cream solder is heated by the laser beam and the cream solder melts. The melted cream solder is cooled, so that the component 2 is soldered to the substrate 1. In the embodiment, the cream solder is irradiated with the laser beam after the liquid component of the cream solder is reduced in the preheating device 13. Since the cream solder is irradiated with the laser beam while the liquid component of the cream solder is reduced, formation of a solder ball due to bumping of the cream solder is suppressed.

The inspection device 15 includes a substrate appearance inspection device (automated optical inspection (AOI)) that inspects the state of the substrate 1 after the component 2 is mounted.

The three-dimensional measuring device 11 is provided with a reading device 101. The mounting device 12 is provided with a reading device 102. The preheating device 13 is provided with a reading device 103. The laser irradiation device 14 is provided with a reading device 104. The reading device 101 reads the substrate data stored in the information medium 80. When the information medium 80 is a two-dimensional code, the reading device 101 is a two-dimensional code reader. When the information medium 80 is an RF tag, the reading device 101 is an RFID reader. Similar to the reading device 101, each of the reading devices 102, 103, and 104 reads the substrate data stored in the information medium 80. Although not illustrated, the inspection device 15 is also provided with a reading device that reads the substrate data stored in the information medium 80.

### Management Device

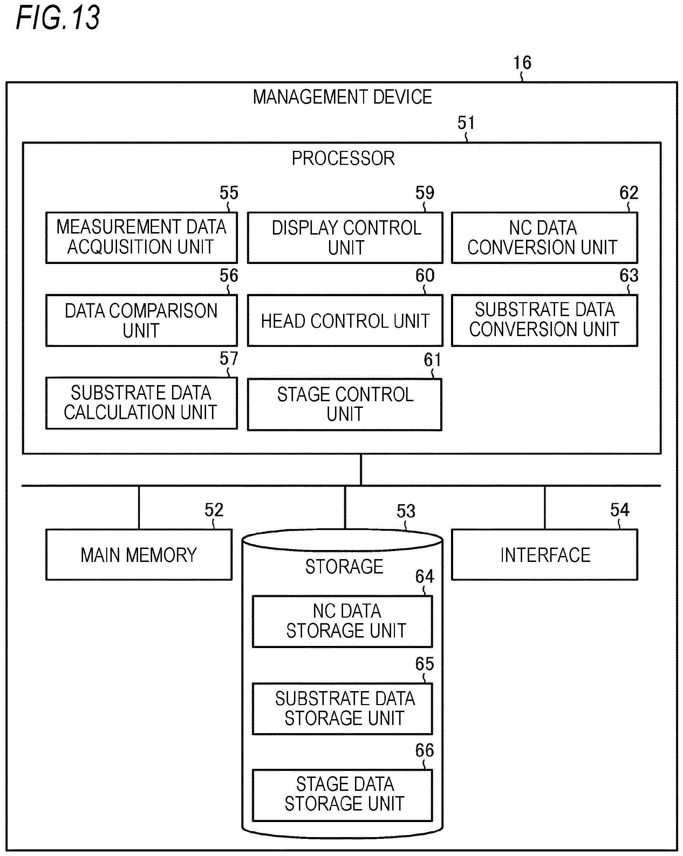

FIG. 13 is a schematic diagram illustrating a configuration of the management device 16 according to the embodiment. The management device 16 may be provided in each of the three-dimensional measuring device 11, the mounting device 12, the preheating device 13, the laser irradiation device 14, and the inspection device 15, or may be provided separately via a network. The management device 16 includes a computer system. The management device 16 controls the production line 17.

The management device 16 includes at least one processor 51, a main memory 52, a storage 53, and an interface 54. The processor 51 is a central processing unit (CPU). The main memory 52 includes a non-volatile memory such as a read only memory (ROM) and a volatile memory such as a random access memory (RAM). Examples of the storage 53 include a hard disk drive (HDD), a solid state drive (SSD), a magnetic disk, a magnetooptical disk, a CD-ROM, and a DVD-ROM. The interface 54 includes an input/output circuit. Functions of the processor 51 are stored as programs in the storage 53. The processor 51 reads the program from the storage 53, loads the program to the main memory 52, and executes processing according to the program. The program may be distributed to the management device 16 via a network.

The processor 51 includes at least one functional unit. In the embodiment, the processor 51 includes a measurement data acquisition unit 55, a data comparison unit 56, a substrate data calculation unit 57, a display control unit 59, a head control unit 60, a stage control unit 61, an NC data conversion unit 62, and a substrate data conversion unit 63. The storage 53 includes an NC data storage unit 64, a substrate data storage unit 65, and a stage data storage unit 66.

The measurement data acquisition unit 55 acquires measurement data of the three-dimensional shape of the surface of the substrate 1 measured by the three-dimensional measuring device 11. The data comparison unit 56 compares design data and measurement data of the surface of the substrate 1 and extracts a mounting position in the measurement data that corresponds to a predetermined mounting position in the design data. The design data is, for example, Gerber data for the film 1B.

The substrate data calculation unit 57 calculates substrate data based on the design data and the measurement data of the three-dimensional measuring device 11. The display control unit 59 displays the display data on the display device 36.

The head control unit 60 controls the mounting head 28. In the embodiment, control of the mounting head 28 includes control of the nozzle 27, control of the head moving device 31, and control of the nozzle moving device 32. The stage control unit 61 controls the stage 24. Control of the stage 24 includes control of the stage moving device 25.

The NC data conversion unit 62 creates NC data, that is operating coordinate data of each device, from the substrate data and mechanical parameters of each device. The substrate data conversion unit 63 creates substrate data from the NC data and the mechanical parameters of each device.

The NC data storage unit 64 stores NC data for each device, that is the operating coordinate data for drive axes of the mounting device 12, the preheating device 13, the laser irradiation device 14, and the inspection device 15. The NC data is generated from the substrate data and the mechanical parameters of each device. The substrate data storage unit 65 stores the substrate data. The substrate data calculated by the substrate data calculation unit 57 is stored in the substrate data storage unit 65. The stage data storage unit 66 stores mechanical parameters calculated in advance that indicate an outer shape and dimensions of the stage 24, a position of a rotation axis Rm of the stage 24 in a machine coordinate system, and a positional relationship between the machine coordinate system and a substrate coordinate system.

### Substrate Data

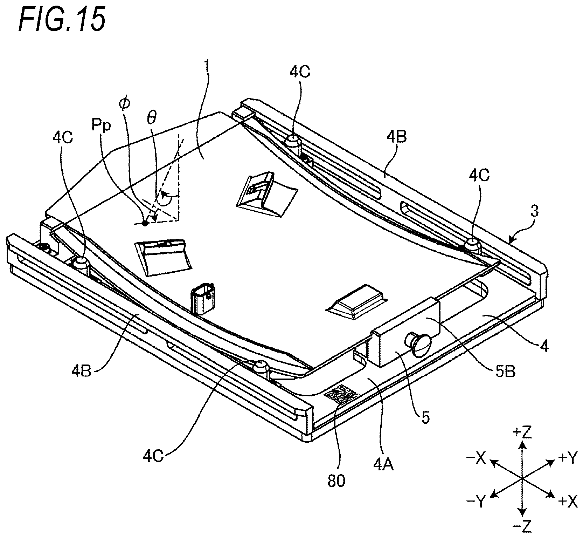

FIGS. 14 and 15 are diagrams illustrating substrate data according to the embodiment. In FIG. 15, deflection angles θ and ϕ are exaggerated for explanation. The substrate data includes a mounting position Pp (xp, yp, zp) of the component 2 on the surface of the substrate 1 and a rotation angle (θxρ, θyp) for horizontally aligning the surface of the substrate 1 at the mounting position Pp, as well as design data such as surface data for the surface of the substrate 1 and texture data for a circuit pattern on the surface data.

The mounting position Pp is based on measurement data obtained by the three-dimensional measuring device 11. In the embodiment, the design data is Gerber data for the film 1B. The design data includes a plurality of mounting positions Pp0 (xp0, yp0, zp0) that are set for each of a plurality of electrodes 1C. The data comparison unit 56 compares base material 1A design data and the measurement data, and the mounting position Pp that corresponds to the mounting position Pp0 in the design data is extracted from the measurement data.

In the embodiment, the substrate data calculation unit 57 converts the mounting position Pp0 and the mounting position Pp from three-dimensional orthogonal coordinates to three-dimensional polar coordinates. The substrate data calculation unit 57 calculates the differential deflection angles θ and ϕ by calculating a difference between the coordinates of the mounting position Pp and the coordinates of the mounting position Pp0. The substrate data calculation unit 57 calculates the rotation angle (θxρ, θyp) for horizontally aligning the surface of the substrate 1 at the mounting position Pp based on the differential deflection angles θ and ϕ.

The substrate data is expressed in a substrate coordinate system (Xp, Yp, Zp) with a substrate coordinate reference point Pr fixed to the substrate 1 or pallet 3 as a starting point. In the embodiment, the substrate coordinate reference point Pr is set at a center of a back surface of the substrate 1. In the embodiment, the Z coordinate of the mounting position Pp0 in the design data is the sum of a thickness of the base material 1A and a thickness of the film 1B. In addition to the above, the substrate data includes the number a component to be mounted, a land position to which the cream solder is applied, a preheating temperature, a preheating time, a laser power, a laser irradiation time, and the like, and is used by each device in the production line 17.

### NC Data

The stage 24 can rotate in the θX and θY directions around the rotation axis Rm. The stage 24 supports the substrate 1 via the pallet 3. When the stage 24 rotates in the θX and θY directions around the rotation axis Rm and the substrate 1 tilts, the mounting position Pp rotates around the rotation axis Rm. The rotation axis Rm is represented by a point in FIG. 14, but the rotation axis may be set separately for each of the θX and θY directions.

A machine coordinate system (Xm, Ym, Zm) is a coordinate system fixed to the mounting device 12, and serves as a reference when the mounting head 28 moves. A starting point of the machine coordinate system may be anywhere on the mounting device 12. When the stage 24 rotates in the θX and θY directions around the rotation axis Rm and the substrate 1 tilts, the mounting position Pp rotates around the rotation axis Rm. A mounting position Pm (xm, ym, zm) in the machine coordinate system of the rotated mounting position Pp is calculated, and the substrate camera 29, the height sensor 30, and the nozzle 27 of the mounting head 28 move using the mounting position Pm (xm, ym, zm). The mounting position Pm (xm, ym, zm) in the machine coordinate system and the rotation angle of the stage 24 are stored as NC data, and are used as command positions for drive motors when the mounting device 12 is in operation. In addition to the mounting device 12, NC data is also created and used in the laser irradiation device 14 and the inspection device 15 in a similar manner. The NC data is calculated from mechanical parameters such as the position of the rotation axis Rm of the stage 24, so the NC data for each device are different.

### Electronic Device Manufacturing Method

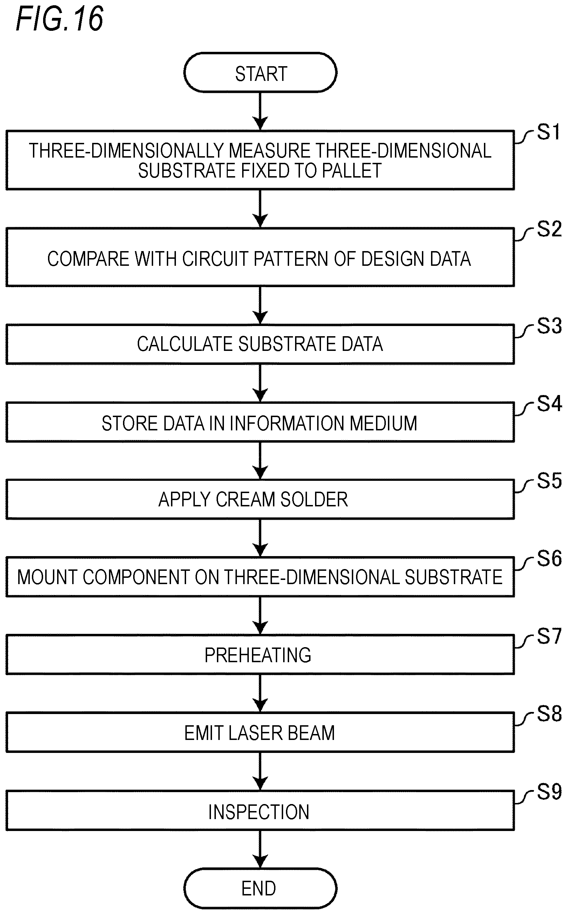

FIG. 16 is a flowchart illustrating an electronic device manufacturing method according to the embodiment. The substrate 1 is fixed to the pallet 3. The substrate 1 fixed to the pallet 3 is carried into the three-dimensional measuring device 11. The three-dimensional measuring device 11 measures a three-dimensional shape of the surface of substrate 1 fixed to the pallet 3. Three-dimensional measurement data indicating the three-dimensional shape of the surface of the substrate 1 measured by the three-dimensional measuring device 11 is transmitted from the three-dimensional measuring device 11 to the management device 16 (step S1).

An electrical circuit is provided on the surface of the substrate 1. The three-dimensional data of the surface of the substrate 1 transmitted to the management device 16 and acquired by the measurement data acquisition unit 55 includes design data such as surface data of the substrate 1 and texture data indicating a pattern of the electrical circuit provided on the surface (in the embodiment, the film 1B) of the substrate 1.

The data comparison unit 56 compares the three-dimensional measurement data of the circuit pattern of the substrate 1 measured by the three-dimensional measuring device 11 with the three-dimensional design data of the circuit pattern of the design data. The data comparison unit 56 compares the three-dimensional measurement data of the circuit pattern of the substrate 1 measured by the three-dimensional measuring device 11 and the three-dimensional design data of the circuit pattern of the design data, for example, using a pattern matching technique.

Three-dimensional design data of the circuit pattern of the design data is constructed in advance based on, for example, design data for an electronic device. Further, a target position for the mounting position Pp0 of the component 2 is defined in the circuit pattern of the design data. A plurality of mounting positions Pp0 are defined on one substrate 1. The data comparison unit 56 compares the three-dimensional measurement data and the three-dimensional design data to extract the mounting position Pp in the three-dimensional measurement data that corresponds to a predetermined mounting position Pp0 defined in the design data (step S2).

The substrate data calculation unit 57 can calculate substrate data indicating the coordinates (xp, yp, zp) of the mounting position Pp of the component 2 on the surface of the substrate 1 and the rotation angle (θxρ, θyp) for horizontally aligning the surface of the substrate 1 at the mounting position Pp. The substrate data calculation unit 57 calculates the coordinates (xp, yp, zp) of the mounting position Pp of the component 2 on the surface of the substrate 1 based on the comparison result by the data comparison unit 56 and the three-dimensional measurement data. The substrate data calculation unit 57 calculates the rotation angle (θxρ, θyp) for horizontally aligning the surface of the substrate 1 at the mounting position Pp based on the difference in coordinates between the mounting position Pp0 (xp0, yp0, zp0) of the three-dimensional design data and the mounting position Pp of the three-dimensional measurement data. The substrate data includes the mounting position Pp as well as the mounted component, the soldering land position, and the like (step S3).

The substrate data calculated in step S3 is stored in the substrate data storage unit 65. The substrate data calculated in step S3 is also held in the information medium 80. When the information medium 80 is a two-dimensional code, a two-dimensional code indicating the substrate data is created in the three-dimensional measuring device 11 and attached to the pallet 3 (step S4). Only the identification number may be recorded in the information medium 80 held in the pallet 3, and the substrate data stored in the substrate data storage unit 65 on a server managing the production system 10 may be referenced.

Substrate data is created and stored for each substrate input into the production system 10. Therefore, for a three-dimensional substrate such as the substrate 1 that is formed using in-mold molding technology and in which aligning the base material 1A with the film 1B containing the circuit pattern is difficult, electronic devices can be manufactured using substrate data of the accurate mounting position Pp measured for each substrate.

When alignment accuracy between the base material 1A and the film 1B including the circuit pattern can be kept within a predetermined standard, it is possible to omit measurement of the second and subsequent substrates 1 by the three-dimensional measuring device 11 and record the same substrate data in the information medium 80, thereby improving efficiency.

The pallet 3 with the information medium 80 attached is conveyed to the mounting device 12 while supporting the substrate 1. The reading device 102 reads the information medium 80 attached to the pallet 3. The dispenser 38 of the mounting device 12 creates NC data using the substrate data read by the reading device 102 from the information medium 80 and mechanical parameters, and applies cream solder to the substrate 1 based on the created NC data. The dispenser 38 applies cream solder to a pad position for the component to be mounted at the mounting position Pp (step S5).

After the cream solder is applied to the substrate 1, the stage control unit 61 controls the stage 24 and the head control unit 60 controls the mounting head 28 so that the component 2 is mounted on the substrate 1. The stage 24 is controlled by the stage control unit 61 so that the surface of the substrate 1 at the mounting position Pp is horizontally aligned. The mounting head 28 mounts the component 2 on the substrate 1 supported by the stage 24 controlled based on the NC data created from the substrate data and the mechanical parameters. The mounting head 28 mounts the component 2 at the mounting position Pp (step S6). The application of cream solder and component mounting are repeated for all components to be mounted on the substrate 1. The application of cream solder and component mounting may be performed all at once after the cream solder is applied to all locations, or the application of cream solder and component mounting may be repeated for each component.

After the component 2 is mounted on the substrate 1, the pallet 3 is conveyed to the preheating device 13 while supporting the substrate 1. The reading device 103 reads the information medium 80 attached to the pallet 3. The preheating device 13 preheats the cream solder applied to the substrate 1 based on the preheat temperature and the preheat time of the substrate data read by the reading device 103 from the information medium 80 (step S7).

After the cream solder is preheated, the pallet 3 is conveyed to the laser irradiation device 14 while supporting the substrate 1. The reading device 104 reads the information medium 80 attached to the pallet 3. NC data is created based on the substrate data read by the reading device 104 from the information medium 80 and the mechanical parameters of the stage data storage unit 66, and the laser head 47 and the stage 45 are controlled based on the created NC data. The laser head 47 is controlled based on the NC data so that the cream solder applied to the substrate 1 is irradiated with a laser beam, and the position of the stage 45 in the Z-axis direction, θX direction, and θY direction is controlled. The cream solder is melted by the laser beam and cooled, so that the component 2 is soldered to the substrate 1 (step S8). The NC data for component mounting is created so that the surface of the substrate 1 at the target component mounting position Pp is horizontally aligned, but the surface of the substrate 1 when irradiated with a laser beam may be tilted within a range that does not cause the component to shift position due to gravity. By intentionally tilting the surface of the substrate 1 when irradiated with a laser beam, the direction of the laser reflected beam on the solder surface can be regulated, thereby preventing the substrate 1 from being burned. The possible angle of tilt is determined by the weight of the component 2 and the adhesive strength of the cream solder, and is stored in advance in the substrate data.

After the component 2 is soldered to the substrate 1, the pallet 3 is conveyed to the inspection device 15 while supporting the substrate 1. A reading device provided in the inspection device 15 reads the information medium 80 attached to the pallet 3. The inspection device 15 inspects the substrate 1 based on the substrate data read from the information medium 80 by the reading device of the inspection device 15 (step S9).

### Mounting Process

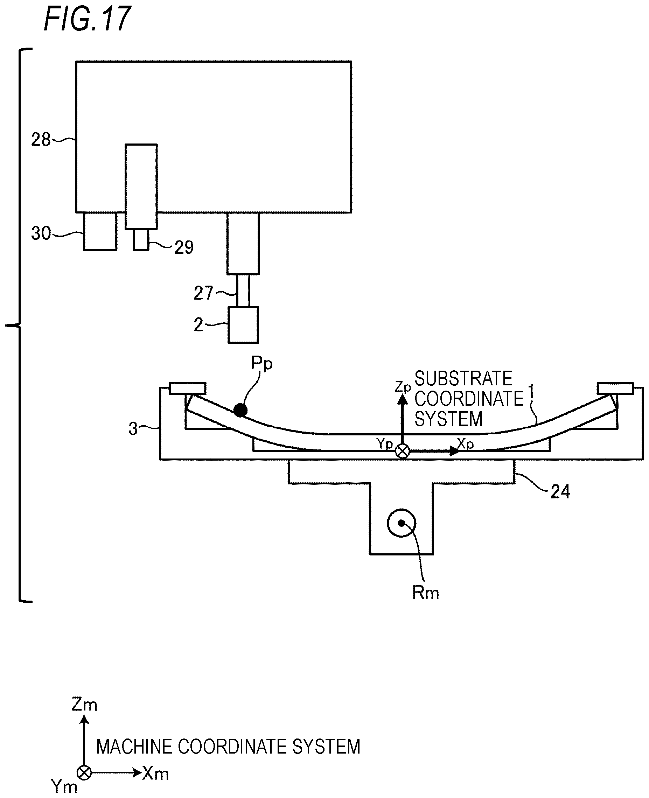

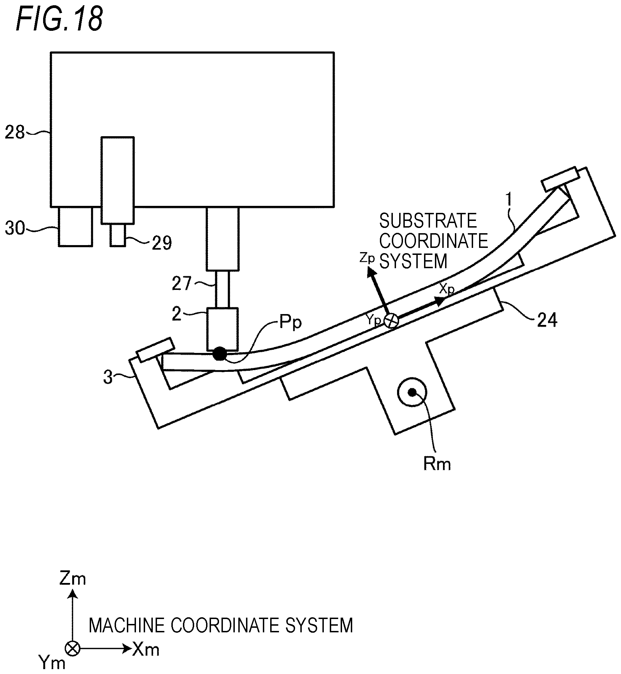

FIGS. 17 and 18 are diagrams illustrating a mounting process by the mounting head 28 according to the embodiment. Substrate data is calculated that indicates the mounting position Pp on the substrate 1 of the component 2 and the rotation angle for horizontally aligning the surface of the substrate 1 at the mounting position Pp. In the embodiment, stage data that indicates the external shape and dimensions of the stage 24, the position of the rotation axis Rm of the stage 24 in the machine coordinate system, and the positional relationship between the machine coordinate system and the substrate coordinate system is calculated in advance and stored in the stage data storage unit 66.

Substrate data including the mounting position Pp on the substrate coordinates and the rotation angle are read from the substrate data storage unit 65. From the read substrate data and stage data, the rotation angles ΘX and θY of the stage 24 required to horizontally align the surface of the substrate 1 for each mounting position Pp are calculated. When the stage 24 is rotated by θX and θY, the mounting position Pp is horizontally aligned.

The rotation angles (θxρ, θyp) for horizontally aligning the surface of the substrate 1 at the mounting position Pp are the rotation angles relative to the orientation measured by the three-dimensional measuring device 11, that is, the rotation angles from a state in which the pallet 3 is in a horizontal orientation. Therefore, the rotation angle ΘX based on the horizontal orientation of the stage 24 is equal to θxp, and the rotation angle θY based on the horizontal orientation of the stage 24 is equal to θyp. When the stage 24 is rotated by θX and θY, the position to which the mounting position Pp moves in the XY direction on the machine coordinate system and the Z direction height of the position are calculated at the same time, and the XY coordinates to which the mounting head 28 should move when mounting a component, the rotation angles θX and θY of the stage 24, and the Z direction height of the stage 24 are stored as NC data.

As illustrated in FIG. 18, the stage control unit 61 controls the stage 24 based on NC data. The head control unit 60 controls the mounting head 28 based on NC data, thereby enabling the mounting head 28 to mount the component 2 at the mounting position Pp on the surface of the substrate 1 parallel to the XY plane.

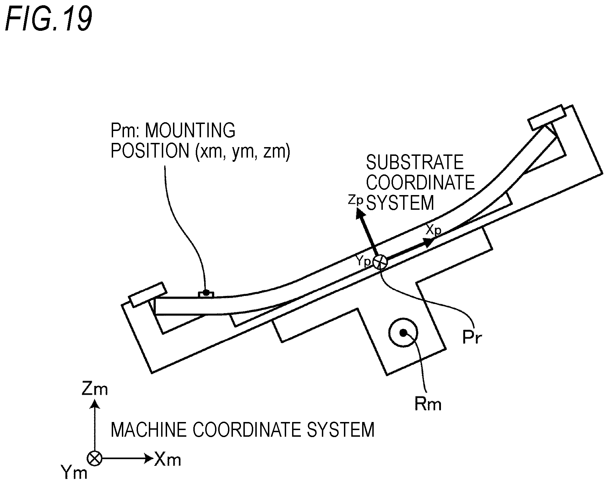

FIG. 19 is a diagram illustrating a method of controlling the stage 24. The mounting position Pp is defined in the substrate coordinate system fixed to the substrate 1. For example, the substrate coordinate reference point Pr is set as the starting point, and the X-axis, Y-axis, and Z-axis directions of the coordinate system are fixed to the substrate 1. The mounting position is expressed as Pp (xp, yp, zp) on the substrate coordinate system. At the same time, the mounting position is also expressed in the machine coordinate system fixed to the mounting device 12. In the machine coordinate system, the mounting position is expressed as Pm (xm, ym, zm). The starting point of the machine coordinate system may be anywhere fixed within the machine. The starting point is usually set at a movable end of an XYZ movable axis of the mounting head 28. Conversion from the substrate coordinate system to the machine coordinate system is performed by the NC data conversion unit 62.

When the stage 24 rotates around the rotation axis Rm, the substrate 1 and the substrate coordinate system also rotate. When the stage 24 moves up and down in the Z-axis direction, the substrate 1 and the substrate coordinate system also move up and down. Therefore, the mounting position Pp (xp, yp, zp) is converted to the mounting position Pm (xm, ym, zm) in the machine coordinate system using the data on the rotation angle and the vertical movement amount of the stage 24, the position of the rotation axis of the stage 24, and the positions of the rotation axis of the stage 24 and a starting point of the substrate coordinate system. The position of the machine coordinate system can also be converted to the position of the substrate coordinate system using a control amount of the stage 24. The conversion from the machine coordinate system to the substrate coordinate system is performed by the substrate data conversion unit 63.

### Effects

As described above, according to the present embodiment, substrate data including a rotation angle for horizontally aligning the surface of the substrate 1 at the mounting position can be calculated based on a coordinate difference between the mounting position in the measurement data of the three-dimensional shape of the surface of the substrate 1 supported by the stage 24 and the mounting position in the design data. Accordingly, the stage 24 can be controlled so that the surface of the three-dimensional substrate at the mounting position is horizontally aligned based on the substrate data, and thus the component 2 can be mounted by the mounting head 28 at the horizontal mounting position.

Since the mounting position can be specified and the rotation angle required to horizontally align the surface can be calculated by comparing design data and measurement data, automatic teaching is possible for a plurality of mounting positions set on the substrate 1. In other words, it is no longer necessary for an operator to manually input mounting positions and normal vectors one by one using a reference substrate, or to check with a camera and adjust errors, as was the case in the related art, and teaching processing can be easily performed on a three-dimensional substrate.

### Other Embodiments

Although the embodiment of the present application is described above, the present invention is not limited to the contents of the embodiments. The embodiment and modification examples described above can be combined as appropriate as long as the embodiments do not cause inconsistencies in the processing content. The elements described above include those that a person skilled in the art could easily imagine, those that are substantially the same, and those that are within a so-called equivalent range. Further, the elements described above can be combined as appropriate. Further, various omissions, substitutions, or modifications of the elements can be made as long as the elements do not deviate from the gist of the embodiment described above.

For example, in the embodiment, a circuit pattern is used to compare the design data and the measurement data of the surface of the substrate 1, but a plurality of alignment marks may be provided on the surface of the substrate 1 and the comparison may be performed using the alignment marks. In addition, before performing step S2, a determination process may be included in which the measurement data is displayed, for example, on a display device, and it is determined that the error with respect to the three-dimensional data of the reference substrate stored in advance is less than a predetermined value.

Further, in each process described in the above embodiment, all or part of the processes described as being performed automatically can be performed manually, or all or part of the processes described as being performed manually can be performed automatically using known methods. In addition, the information including processing procedures, specific names, various pieces of data, and parameters shown in the above documents and drawings can be changed as desired unless otherwise specified. For example, the various pieces of information shown in each drawing is not limited to the information shown in the drawings.

Further, each element of each device shown in the figure is a functional concept and does not necessarily have to be physically configured as shown. In other words, the specific form of distribution and integration of each device is not limited to the form shown in the figure, and all or part of the devices can be functionally or physically distributed and integrated in any unit depending on various loads, usage conditions, and the like. Further, the above-described management device 16 may be configured by a plurality of computers divided into several functions, and some of the functions of the computers may be provided in a cloud server that executes various functions in the form of cloud computing.

### REFERENCE SIGNS LIST

1: substrate
1A: base material
1B: film
1C: electrode
2: component
3: pallet
4: support member
4A: base portion
4B: guard portion
4C: pin portion
4D: hole
5: clamp mechanism
5A: support portion
5B: movable portion
10: production system
11: three-dimensional measuring device
12: mounting device
13: preheating device
14: laser irradiation device
15: inspection device
16: management device
17: production line
18: base member
19: conveying device
19A: conveying belt
19B: guide member
20: sensor
21: chamber
22: base member
23: conveying device
23A: conveying belt
23B: guide member
24: stage
24A: positioning member
25: stage moving device
26: component supply device
27: nozzle
27A: shaft
28: mounting head
29: substrate camera
30: height sensor
31: head moving device
31X: X-axis moving device
31Y: Y-axis moving device
32: nozzle moving device
33: chamber
34: opening/closing cover
35: window
36: display device
37: input device
38: dispenser
39: base member
40: conveying device
40A: conveying belt
40B: guide member
41: heater
42: chamber
43: base member
44: conveying device
44A: conveying belt
44B: guide member
45: stage
46: stage moving device
47: laser head
48: chamber
49: opening/closing cover
50: window
51: processor
52: main memory
53: storage
54: interface
55: measurement data acquisition unit
56: data comparison unit
57: substrate data calculation unit
59: display control unit
60: head control unit
61: stage control unit
62: NC data conversion unit
63: substrate data conversion unit
64: NC data storage unit
65: substrate data storage unit
66: stage data storage unit
80: information medium
101: reading device
102: reading device
103: reading device
104: reading device
Pp: mounting position (substrate coordinate)
Pp0: mounting position
Pm: mounting position (machine coordinate)
Pr: substrate coordinate reference point
Rm: rotation axis

## Claims

1. A mounting device comprising:
a stage configured to support a three-dimensional substrate;
a mounting head configured to mount a component on the three-dimensional substrate;
a measurement data acquisition unit configured to acquire measurement data of a three-dimensional shape of a surface of the three-dimensional substrate;
a data comparison unit configured to: compare design data and the measurement data of the surface of the three-dimensional substrate; and extract a mounting position in the measurement data corresponding to a predetermined mounting position in the design data;
a substrate data calculation unit configured to calculate substrate data including a rotation angle for horizontally aligning the surface of the three-dimensional substrate at the mounting position based on a difference in coordinates between the design data and the measurement data at the mounting position;
a stage control unit configured to control the stage to horizontally align the surface of the three-dimensional substrate at the mounting position based on the substrate data; and
a head control unit configured to control the mounting head so that the component is mounted at the mounting position while the surface of the three-dimensional substrate at the mounting position is horizontally aligned.

2. The mounting device according to claim 1, wherein
the three-dimensional substrate includes a base material having a curved surface, and a film including an electric circuit bonded to the surface of the base material, and
the data comparison unit compares a pattern of the electric circuit and the measurement data.

3. The mounting device according to claim 1, wherein
the substrate data calculation unit calculates a rotation angle for horizontally aligning the surface of the three-dimensional substrate based on a difference between a deflection angle of the design data of the mounting position converted into three-dimensional polar coordinates and a deflection angle of the measurement data.

4. An electronic device manufacturing system comprising:
a pallet configured to support the three-dimensional substrate;
a three-dimensional measuring device configured to measure a three-dimensional shape of the surface of the three-dimensional substrate fixed to the pallet and outputs measurement data; and
a mounting device according to any one of claims 1 to 3, where cream solder is applied to the three-dimensional substrate conveyed from the three-dimensional measuring device while the three-dimensional substrate is fixed to the pallet, and the component is mounted at the mounting position.

5. A mounting method comprising:
acquiring measurement data of a three-dimensional shape of a surface of a three-dimensional substrate supported by a stage;
comparing design data and the measurement data of the surface of the three-dimensional substrate, and extracting a mounting position in the measurement data corresponding to a predetermined mounting position in the design data;
calculating substrate data including a rotation angle for horizontally aligning the surface of the three-dimensional substrate at the mounting position based on a difference in coordinates between the design data and the measurement data at the mounting position;
controlling the stage to horizontally align the surface of the three-dimensional substrate at the mounting position based on the substrate data; and
mounting a component at the mounting position using a mounting head while the surface of the three-dimensional substrate at the mounting position is horizontally aligned.

6. An electronic device manufacturing method comprising:
applying cream solder to the three-dimensional substrate; and
mounting the component on the three-dimensional substrate using the mounting method according to claim 5.
